(19) Europäisches Patentamt
European Patent Office
Office européen des brevets

(11) **EP 2 939 279 B1**

(12) **EUROPÄISCHE PATENTSCHRIFT**

(45) Veröffentlichungstag und Bekanntmachung des Hinweises auf die Patenterteilung:
**13.02.2019 Patentblatt 2019/07**

(21) Anmeldenummer: **13811987.0**

(22) Anmeldetag: **23.12.2013**

(51) Int Cl.:
*H01L 35/28* (2006.01)     *H01L 35/32* (2006.01)

(86) Internationale Anmeldenummer:
**PCT/EP2013/077901**

(87) Internationale Veröffentlichungsnummer:
**WO 2014/102239 (03.07.2014 Gazette 2014/27)**

(54) **THERMOELEKTRISCHER KONVERTER**

THERMOELECTRIC CONVERTER

CONVERTISSEUR THERMOÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.12.2012 CH 29932012**

(43) Veröffentlichungstag der Anmeldung:
**04.11.2015 Patentblatt 2015/45**

(73) Patentinhaber: **Greenteg AG**
**8005 Zürich (CH)**

(72) Erfinder:
• **DURRER, Lukas**
  **CH-9642 Ebnat-Kappel (CH)**
• **HELBLING, Thomas**
  **CH-8500 Frauenfeld (CH)**
• **SCHWYTER, Etienne**
  **CH-6343 Buonas (CH)**
• **GLATZ, Wulf**
  **CH-8005 Zürich (CH)**
• **STEIN, Peter**
  **CH-8004 Zürich (CH)**

(74) Vertreter: **Schneider Feldmann AG**
**Patent- und Markenanwälte**
**Beethovenstrasse 49**
**Postfach**
**8027 Zürich (CH)**

(56) Entgegenhaltungen:
**WO-A1-2012/086775     US-A- 5 441 576**
**US-A1- 2007 220 902     US-A1- 2010 212 711**

**Beschreibung**

Die Erfindung betrifft einen thermoelektrischen Konverter (TEK) resp. ein thermoelektrisches Element und dessen Verwendung.

Ein thermoelektrischer Konverter kann als thermoelektrischer Generator (Seebeck Effekt), als thermoelektrischer Kühler (Peltier Effekt) oder als thermoelektrischer Sensor ausgeprägt sein. Thermoelektrische Konverter (TEK) resp. Thermoelemente sind bekannt und werden bereits industriell eingesetzt.

Thermoelektrische Generatoren werden zur Konversion eines Wärmeflusses (Wärmeenergie) in ein elektrisches Potential verwendet. Das elektrische Potential kann durch Anschluss eines Verbrauchers über den Stromfluss als elektrische Energiequelle genutzt werden. Thermoelektrische Generatoren werden beispielsweise für Energieautarke Sensorik verwendet, zum Beispiel in der Gebäudetechnik. Thermoelektrische Kühler/Heizer (Peltier-Elemente) werden zum Beispiel in biochemischen Laboratorien zur raschen Kühlung von Proben eingesetzt. Thermoelektrische Sensoren, insbesondere Wärmeflusssensoren, werden unter anderem in der Gebäudetechnik zur Messung des thermischen Isolierungsvermögens von Wänden verwendet.

Der Aufbau eines TEKs umfasst zwei parallele thermische Grenzflächen. Zwischen den beiden thermischen Grenzflächen befinden sich die thermoelektrischen Materialien vom n-Typ resp. p-Typ in der Form von parallel zueinander und orthogonal zu den Grenzflächen ausgerichteten Säulen (Thermosäulen). In den meisten Fällen (Serienschaltung) sind die Thermosäulen in abwechselnder Reihenfolge (p- und n-Säulen alternierend) angeordnet. Jede Thermosäule ist sowohl eine elektrische als auch eine thermische Verbindung zwischen den beiden thermischen Grenzflächen. Diese Thermosäulen sind auf ihren Stirnseiten, d. h. den Seiten, welche den thermischen Grenzflächen zugewandt sind, je nach Anwendungsfall elektrisch in Serie oder parallel miteinander verbunden. Im Falle einer elektrischen Serienschaltung verbindet die elektrische Schaltverbindung jeweils eine Thermosäule mit einer Thermosäule immer um eine Position versetzt.

Durch den Kontakt der einen thermischen Grenzfläche mit einer Wärmequelle und der anderen Grenzfläche mit einer Wärmesenke, entsteht ein thermischer Gradient über den Thermosäulen. Dieser thermische Gradient führt zu einem thermischen Fluss, welcher von der wärmeren Grenzfläche zur kälteren Grenzfläche des TEKs fliesst. Der Temperaturgradient führt zu einer Temperaturdifferenz zwischen der Oberfläche der Thermosäule auf der Seite der wärmeren Grenzfläche zur Oberfläche auf der Seite der kälteren Grenzfläche. Durch diese Temperaturdifferenz entsteht eine elektrische Spannung in den Thermosäulen (Thermospannung, Seebeck Effekt).

Durch die Verbindung der elektrisch in Serie oder parallel kontaktierten Thermosäulen mit einem elektrischen Verbraucher fliesst ein elektrischer Strom (thermoelektrischer Generator).

Durch die Verbindung der in Serie oder parallel elektrisch kontaktierten Thermosäulen mit einer Stromquelle, fliesst ein Strom, wodurch die eine Grenzschicht gekühlt und die gegenüberliegende Grenzschicht erhitz wird (Peltier Element).

Die Herstellung von TEKs erfolgt grundsätzlich mit Technologien, die aus der Halbleiterfertigung bekannt sind. Konventionelle TEKs werden hergestellt, indem die Thermosäulen aus gegossenem oder aus der Schmelze gezogenem thermoelektrischem Material ausgesägt werden, diese dann angeordnet und auf der unteren und oberen Seite verlötet werden. Die Lötstellen befinden sich auf zwei starren Platten (häufig aus keramischem Material bestehend), welche zugleich thermisch hoch leitfähige Elemente sind. Nachteil dieses Herstellungsverfahrens ist die schlechte Skalierbarkeit und Automatisierbarkeit, was sich in einem teuren Produkt widerspiegelt.

Mikro-TEKs werden industriell mit den Verfahren aus der Mikrosystemtechnik hergestellt. US 6,300,150 B1 und DE19845104 A1 beschreiben ein Verfahren, wie die thermoelektrischen Materialien auf Wafer gesputtert werden. Daraus werden die Thermosäulen geätzt. Anschliessend wird eine Platte mit p- und eine mit n-Material gegeneinander gepresst und so verbunden. Die Si-Wafer bilden dabei ein thermisch hochleitendes Thermoleitelement. Nachteil dieser Methode ist, dass die Dicken der Thermosäulen maximal 40um sind und dass auch diese Methode nur bedingt skaliert werden kann. Zudem macht die Vakuumtechnologie die Herstellung der TEKs zusätzlich teuer.

WO 2008061823 A2 beschreibt ein kostengünstiges und skalierbares Herstellungsverfahren von TEKs basierend auf thermoelektrischen Materialien in einem vorstrukturierten stabilisierenden Matrixmaterial. Das thermoelektrische Material kann mittels unterschiedlicher Verfahren, wie zum Beispiel ball milling, elektrochemische Abscheidung, etc. in den Löchern hergestellt werden. In einem weiteren Schritt werden auf den Matrixoberflächen die elektrischen Verbindungen zwischen den Thermosäulen hergestellt. Die Oberflächen der Matrix mit den elektrischen Verbindungen stellen die thermischen Grenzflächen dar. Es kann auch zusätzlich eine elektrisch isolierende Schicht und/oder ein thermisches hochleitfähiges Thermoelement auf diese Grenzflächen gebracht werden. Vorteil an diesem Prozess ist, dass er skalierbar und automatisierbar und deshalb kostengünstig ist.

Verschiedene Ausführungsformen dieser Herstellungsmethoden sind bekannt. Bei einem thermoelektrischen Element gemäss US-B-6519947 sind einzelne p- und n-dotierte Halbleiter durch einen Spalt voneinander getrennt, wobei der Spalt, sich stark verjüngend, bis in eine Deckschicht reicht.

Die US-A-2005/0126184 offenbart eine thermoelektrische Wärmepumpe mit einem Array in rippenartiger Struktur aus voneinander beabstandeten Rippen in einer Einbettungsmasse. Zwischen Rippen und der Kaltseite sind abwechselnd thermoelektrische Verbinder angeordnet.

Die US2013/0269743 offenbart eine thermoelektrische Leistungserzeugung.

Eine vielversprechende Anwendung von TEKs ist die Bereitstellung von kleinen Mengen an elektrischer Leistung (Mikrowatt bis Milliwatt) aus einer Wärmedifferenz zwischen einer lokalen Wärmequelle und der Umgebungstemperatur als Wärmesenke. Die elektrische Energie kann verwendet werden, um z.B. autonome Sensoren zu betreiben. In der Anwendung müssen die TEKs thermisch zwischen der Wärmequelle und der Wärmesenke angebunden werden. Damit die elektrische Energie genutzt werden kann, muss die vom TEK generierte elektrische Spannung durch eine elektrische Schaltung aufbereitet werden (DC/DC-Booster-Schaltung). Diese elektrische Schaltung beginnt erst ab einer bestimmten Mindestspannung am TEK zu arbeiten, üblicherweise ab 200 mV bis 300 mV. Es ist das Ziel, bei möglichst geringer Temperaturdifferenz zwischen der Wärmequelle und Senke die elektrische Schaltung zu betreiben. Die Ausgangsspannung des TEK muss daher in der Anwendung maximiert werden. Die Spannung hängt von verschiedenen Faktoren ab, wie der Güte des thermoelektrischen Materials, der thermischen Leitfähigkeit des TEK Moduls und den thermischen Anschlussbedingungen der Anwendung. Mikro-TEKs weisen durch ihre kleine Dimension und der hohen Dichte an Thermosäulen bei bereits geringen Temperaturdifferenzen hohe Spannungen auf. Sie sind jedoch ausgesprochen brüchig, schwierig zu integrieren und teuer. Konventionelle TEKs weisen eine geringe Dichte an Thermosäulen auf und kommen daher nur bei hohen Temperaturdifferenzen auf die geforderten Spannungen. Zudem sind sie teuer und gross. Kostengünstig herstellbare TEKs, bei welchen das thermoelektrische Material in eine Matrix eingebettet ist, weisen eine mittlere Dichte an Thermosäulen auf und besitzen eine hohe thermische Leitfähigkeit. Die thermische Leitfähigkeit dieser TEKs ist verglichen mit den Mikro-TEKs hoch, weil sowohl das thermoelektrische Material als auch das Matrix Material hohe thermische Leitfähigkeiten aufweisen. Bei den Mikro-TEKs weisen nur die Thermosäulen eine hohe thermische Leitfähigkeit auf, die Säulen sind in Luft eingebettet.

Der Erfindung liegt daher die Aufgabe zugrunde, einen thermoelektrischen Konverter (TEK) resp. ein Thermoelement zu entwickeln, basierend auf dem skalierbarem Herstellungsprozess mittels der stabilisierenden Matrix, welcher eine geringe thermische Leitfähigkeit aufweist. Die Aufgabe ist mit den Merkmalen des Patentanspruchs 1 gelöst. Vorgeschlagen wird eine Gestaltung von TEK, die es ermöglicht, den Wärmefluss direkt von einem thermisch hochleitfähigen Wärmeleitelement (heat conductive plate) an den äusseren thermischen Grenzflächen eines TEKs in die Halbleiter (Pile, Thermosäule) zu leiten. Dies wird bei gegebener thermischer Anbindung der thermischen Grenzflächen an eine kalte und warme Seite erreicht, indem der parasitäre Wärmestrom durch das Matrix-Material minimiert wird. Um dies zu ermöglichen, sieht die Erfindung vor, dass dieses hochleitfähiges Material nur mit den elektrischen Kontakten und in bevorzugter Weise nur mit denjenigen Teilen der elektrischen Kontakte in gutem thermischem Kontakt ist, unter welchen sich die Thermosäulen befinden. Zwischen diesen Kontaktflächen befindet sich ein thermisch schlecht leitendes Medium wie Luft oder Vakuum oder ein Material wie geschäumtes Polymer oder allgemein eine Unterbrechung resp. Aussparung, so dass der thermische Kontakt zum Matrixmaterial minimiert wird.

Im Falle eines elektrisch leitenden Wärmeleitelements ist zwischen den Grenzschichten des Wärmeleitelements und den elektrischen Kontakten eine elektrische Isolationsschicht vorgesehen, die die elektrischen Kontakte der Säulen vom Wärmeleitelement elektrisch isoliert.

In verallgemeinerter Form ist die Aufgabe durch verbessertes räumliches und thermisches Design des TEKs gelöst. Der erfindungsgemässe TEK bietet wesentlich grössere Freiheit in der Wahl des Matrixmaterials, da dieses nicht in Bezug auf eine geringe Wärmeleitfähigkeit optimiert sein muss. Somit können die räumliche Gestaltung und Herstellbarkeit eines TEKs und die Vermeidung parasitärer Wärmeflüsse getrennt betrachtet werden.

Vorteilhafte Ausgestaltungen sind in den abhängigen Ansprüchen offenbart. Die thermische Isolationsschicht sollte eine thermische Leitfähigkeit aufweisen, welche geringer ist als die des gewählten Matrix-Materials. Als Isolationsschicht sind dünne Luft- oder Vakuumpolster optimal. So genügt eine beidseitige Luftschicht von wenigstens 2 um, um ein Effekt zu erzielen. Beispielsweise vermag eine beidseitige Luftschicht von je 30 um um eine Matrix/Halbleiter mit einer Dicke von 200 um, die parasitäre Wärmeleitfähigkeit von 0,5 W/m/K (Polymer-Matrix) auf 0,03 W/m/K zu senken. D. h. der parasitäre Wärmefluss wird um den Faktor 16 reduziert, was den Wirkungsgrad des erfindungsgemässen TEK deutlich erhöht. Die Schaltverbindungen (Kontakte), die Isolationsschichten, sowie die thermisch hochleitfähigen Wärmeleitelemente können auf den verschiedenen Seiten (kalt, warm) verschieden sein, da auf beiden Seiten unterschiedliche Temperaturen herrschen und unterschiedliche Werkstoffe vorteilhaft sein können.

Die Erfindung wird nachfolgend in Ausführungsbeispielen anhand einer Zeichnung näher beschrieben. In der Zeichnung zeigen die

Fig. 1: eine Funktionsskizze mit Beispiel einer thermischen Integration eines TEKs in ein System (a) und ein thermisches Ersatzschaltbild (b) eines TEKs mit Wärmequelle und Wärmesenke,

Fig. 2: Querschnitt durch einen TEK des Standes der Technik (a), sowie mit typischem thermisch hochleitfähigem Wärmeleitelement (heat conductive plate) (b),

Fig. 3: Querschnitt durch einen erfindungsgemässen TEK,

Fig. 4: weitere Ausführungsformen des erfindungsgemässen TEKs, in denen die elektrische Isolation variiert ist (a-d),

Fig. 5: weitere Ausführungsformen, in denen die Matrix topologisch verändert ist (a-c),

Fig. 6: weitere Ausführungsformen, in denen die Geometrie der Schaltverbindungen variiert ist (a-c),

Fig. 7: weitere Ausführungsformen, in denen das Wärmeleitelement variiert ist (a-b),

Fig. 8: Kontaktgestaltung für die Reflow-Variante (a-c),

Fig. 9: Ausführungsformen mit übereinandergestapelten TEKs (a-c) .

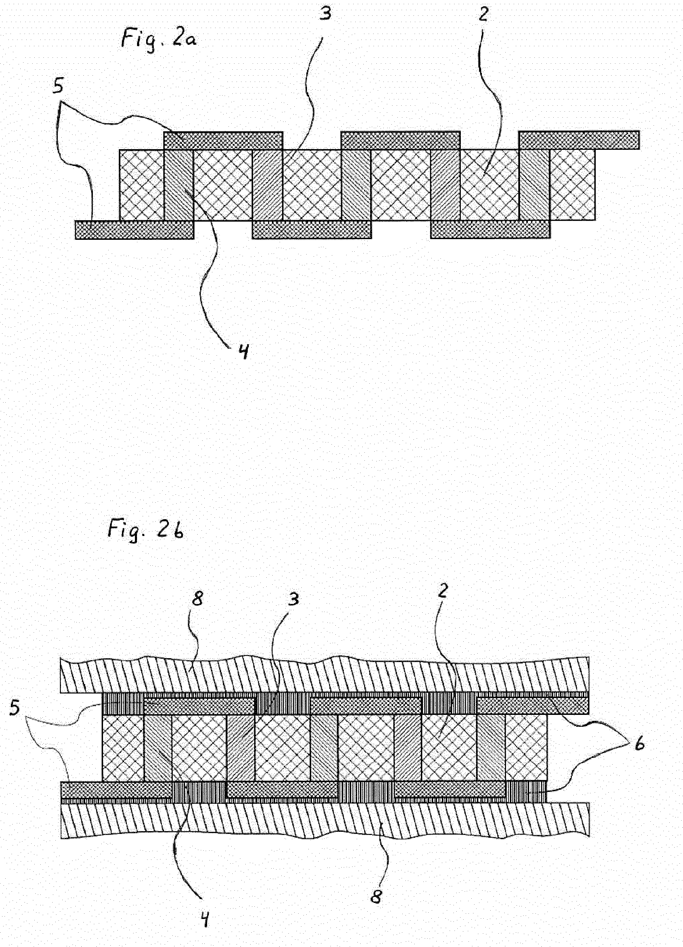

Ein nach einer matrixbasierten Herstellungsmethode gefertigter thermoelektrischer Konverter (TEK) in der Ausführung nach dem eingangs beschriebenen Stand der Technik ist aus der Figur 2 ersichtlich, einschliesslich typischer Wärmeleitelemente (heat conductive plate) (8, 9) (Fig. 2b) angebracht mit Wärmeleitkleber oder normalem herkömmlichen Kleber (15). Luft- oder Vakuumeinschlüsse sind nicht vorhanden.

Zwischen zwei thermischen Grenzflächen eines konventionellen TEKs (Fig. 2a) sind die weiteren Elemente angeordnet. In einer Matrix 2, einem Hüllmaterial, befinden sich die thermoelektrischen Materialien 3, 4 vom n-Typ resp. p-Typ in der Form von parallel zueinander und orthogonal zu den Grenzflächen ausgerichteten Säulen (Thermosäulen). In den meisten Fällen (Serienschaltung) sind die Thermosäulen in abwechselnder Reihenfolge (p- und n-Säulen alternierend) in einer Matrix (2) angeordnet resp. eingebettet. Jede Thermosäule (3, 4) ist sowohl eine elektrische als auch eine thermische Verbindung zwischen den beiden thermischen Grenzflächen. Diese Thermosäulen sind auf ihren Stirnseiten (den Seiten, welchen den thermischen Grenzflächen zugewandt sind) je nach Anwendungsbedarf elektrisch in Serie oder parallel mittels elektrischen Schaltverbindungen (5) miteinander verbunden. Im Falle einer Serienschaltung verbindet die elektrische Schaltverbindung (5) jeweils eine Säule des n-Typs (3) mit einer Säule des p-Typs(4) immer um eine Position versetzt.

Je nach Ausführung sind die thermischen Grenzflächen noch mit einer elektrisch isolierenden Schutzschicht (6) überzogen. In einer weiteren Ausführung sind an den thermischen Grenzflächen jeweils thermisch hochleitfähige Wärmeleitelemente (8, 9) mittels eines Wärmeleitklebers oder eines normalen Klebers (15) angebracht.

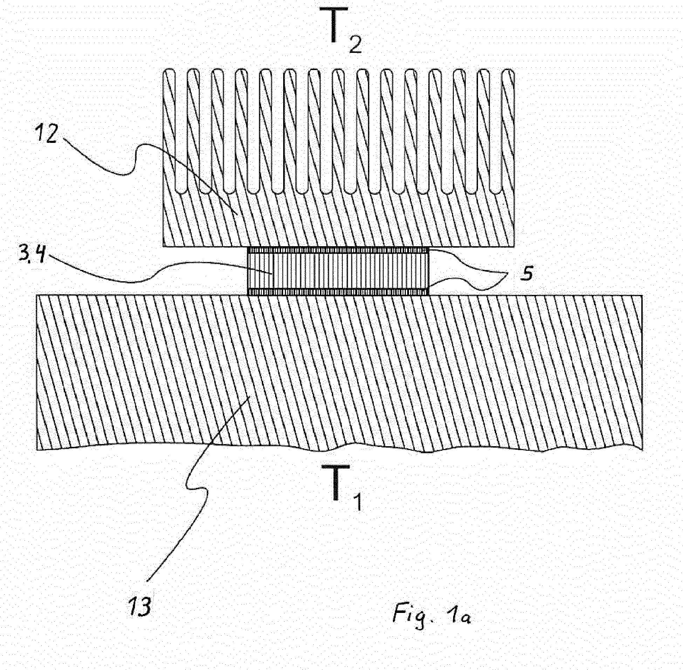

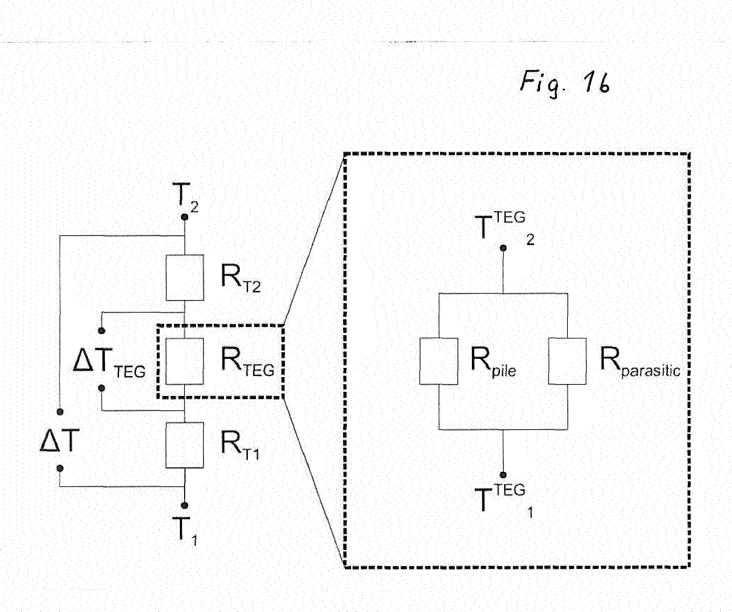

Figur 1 zeigt ein Beispiel einer thermischen Integration eines TEKs anhand einer Funktionsskizze (a) und eines thermischen Ersatzschaltbildes (b) in einer typischen Anwendung, wo die warme Grenzfläche des TEKs thermisch an einen Festkörper angebracht ist und die kalte Grenzfläche an einen Kühlkörper angebracht ist. In Figur 1a ist der TEK zwischen einer Wärmequelle (warme Seite) (13) und einer Wärmesenke (kalte Seite) mit Hilfe eines thermisch leitfähigen Montagematerials (Wärmeleitpaste oder Transferklebefolie)(16) integriert. In gewissen Fällen sind die Wärmeleitelemente (Fig. 2b 8, 9) direkt durch die Wärmequelle (13) und dem Wärmeabflusselement (12) gegeben und können somit fehlen. Auch in diesem Falle sind beim Stand der Technik keine Luft- oder Vakuumeinschlüsse vorhanden.

$$\Delta T \; = \; T_1 - T_2 \tag{1}$$

$$\Delta T_{TEK} = \; K_{TEK} / (K_{T1} + K_{T2} + K_{TEK}) * \Delta T \tag{2}$$

$$Q \; = \; \Delta T / (K_{T1} + K_{T2} + K_{TEK}) \tag{3}$$

$$\Delta T_{TEK} \; = \; K_{TEK} * Q \tag{4}$$

$$K_{TEK} \; = \; (K_P * K_{PAR}) / (K_P + K_{PAR}) \tag{5}$$

$$U_{TEK} \; = \; \alpha * m * \Delta T_{TEK} \tag{6}$$

$$P_{TEK} = U_{TEK}^2/4R_G = (\alpha*m*\Delta T_{TEK})^2/(4*R_G) \qquad (7)$$

Bei einer gegebenen Systemtemperaturdifferenz ($\Delta T$) zwischen einem Medium (Festkörper), im Beispiel 60°C, und der Umgebung (Luft), im Beispiel 23°C (d.h. $\Delta T = 37$°C), soll die Temperaturdifferenz über den TEK ($\Delta T_{TEK}$) mit Hilfe eines verbesserten räumlichen und thermischen Designs des TEKs maximiert werden. Dadurch werden bei gegebener Anzahl thermoelektrischer n- und p-Säulenpaare (m) und Seebeck-Spannung ($\alpha$), sowie elektrischen Widerstand des TEKs ($R_g$) die TEK-Spannung ($U_{TEK}$) und -Leistung ($P_{TEG}$) maximiert (Formeln 6 und 7).

Wenn die thermischen Anschlusswiderstände ($K_{T1}$, $K_{T2}$) viel grösser als $K_{TEK}$ sind, was in realen Anwendungen wie in Figur 1 gezeigt oft der Fall ist, wird der Wärmefluss (Q) näherungsweise einzig durch die Anschlusswiderstände ($K_{T1}$, $K_{T2}$) und das $\Delta T$ definiert (Formel 3). Die über den TEK abfallende Temperaturdifferenz $\Delta T_{TEK}$ ist dann proportional zu $K_{TEK}$ (Formel 4, Q = const). Bei gegebenem thermischem Widerstand ($K_P$) der thermoelektrischen Halbleitermaterialen (3,4) eines TEKs (1) wird $K_{TEK}$ maximiert und geht gegen $K_P$, indem $K_{PAR}$ gegen unendlich geht (Formel 5). Es muss daher das Ziel sein, $K_{PAR}$ zu maximieren, um $\Delta T_{TEK}$ in einem gegebenen System zu maximieren. Dies hat zur Folge, dass sowohl $U_{TEK}$ als auch $P_{TEK}$ maximiert sind.

Die Optimierung des TEKs in Bezug auf grösstmögliches $K_{PAR}$ wird nachfolgend in mehreren Beispielen beschrieben.

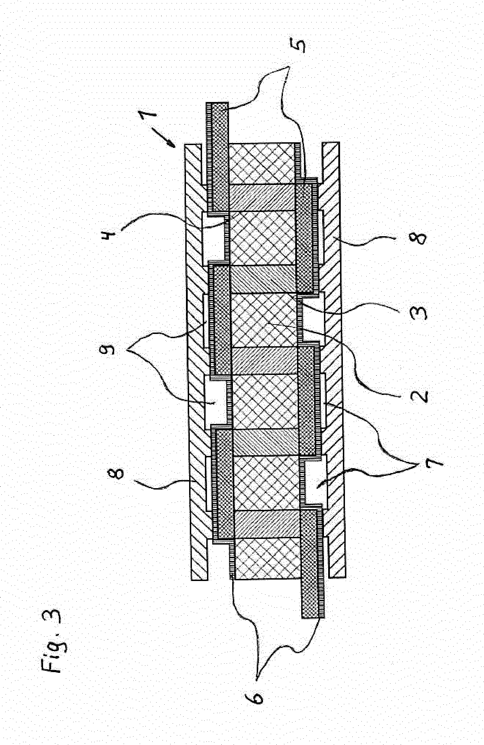

Figur 3 zeigt den Aufbau eines erfindungsgemässen TEKs in seinen wesentlichen Elementen. Zwischen zwei thermischen Grenzflächen sind die weiteren Elemente angeordnet. In einer Matrix 2, einem Hüllmaterial, befinden sich die thermoelektrischen Materialien (3, 4) vom n-Typ resp. p-Typ in der Form von Piles (Thermosäulen). Die Thermosäulen sind parallel voneinander beabstandet und sind ortagonal zu den thermischen Grenzflächen ausgerichtet. In den meisten Fällen (Serienschaltung) sind die Thermosäulen in abwechselnder Reihenfolge (p- und n-Type alternierend) in einer Matrix (2) angeordnet resp. eingebettet. Jede Thermosäule (3, 4) ist sowohl eine elektrische als auch eine thermische Verbindung zwischen den beiden thermischen Grenzflächen. Diese Thermosäulen sind auf ihren Kopf- und Stirnseiten (den Seiten, welchen den thermischen Grenzflächen zugewandt sind) je nach Anwendungsfall elektrisch in Serie oder parallel miteinander verbunden. Im Falle einer Serienschaltung verbindet die elektrische Schaltverbindung (5) jeweils einen Halbleiter des n-Typs (3) mit einem Halbleiter des p-Typs (4) immer um eine Position versetzt. Auch im erfindungsgemässen TEK ist an den thermischen Grenzflächen beidseitig ein Wärmeleitelement (8, 9) über eine elektrisch isolierende Schicht (6) angebracht. Zwischen den Wärmeleitelementen und dem Matrix-Material befinden sich flächige Luftpolster (7, 10), während sich zwischen den Thermosäulen und dem Wärmeleitelement keine Luftpolster befinden, damit der thermische Fluss direkt in die Thermosäulen geleitet wird und nicht über dem Matrix-Material abfällt.

Dabei können die Halbleiter (3, 4) aus Bi2Te3, SbTe, SbBiTe, Se,Bi,Te, Cu, Ni, SbBi, ZnBi, ZnTe, ZnSb o. a. bestehen.

Die Matrix (2) kann aus einem Kunststoff, z. B. PI, PET, PES, PEEK aber auch aus Glas, Si, SiO2, PCB-Werkstoffen o. a. bestehen, deren Wärmeleitfähigkeit grösser ist als die von Luft.

Die Schaltverbindung (5) ist ein Sandwich bestehend aus optional einer oder mehreren Diffusionsbarrieren, z. B. aus Pd, Ni, Ti, Cr, Nitrid, Au, Sb, oder anderen Materialien und Legierungen und einem elektrischen Leiter bestehend aus z. B. Cu. Die Wärmeleitelemente (8,9) können aus Cu, Au, Pd, Al, Sb, Stahl oder einem anderen Metall bestehen, ebenso aus Keramik oder Graphit sein. Sie können folienartig oder geformt sein, z. B. ein Uhrengehäuse oder die Wand eines Wärmetauschers (heisse Seite).

Die elektrische Isolationsschicht (6) kann aus einem Polymer, einem keramischen Werkstoff (z. B. Al2O3), einem thermisch leitfähigen Polymer, einer thermisch leitfähigen Folie aus Keramik o. a. bestehen.

Die flächigen Luftpolster (7, 10) können aus Luft oder Vakuum bestehen, eine Aussparung o. dgl. darstellen oder aus einem beliebigem Medium oder Material mit einer Wärmeleitfähigkeit die geringer ist als jene des Matrixmaterials bestehen.

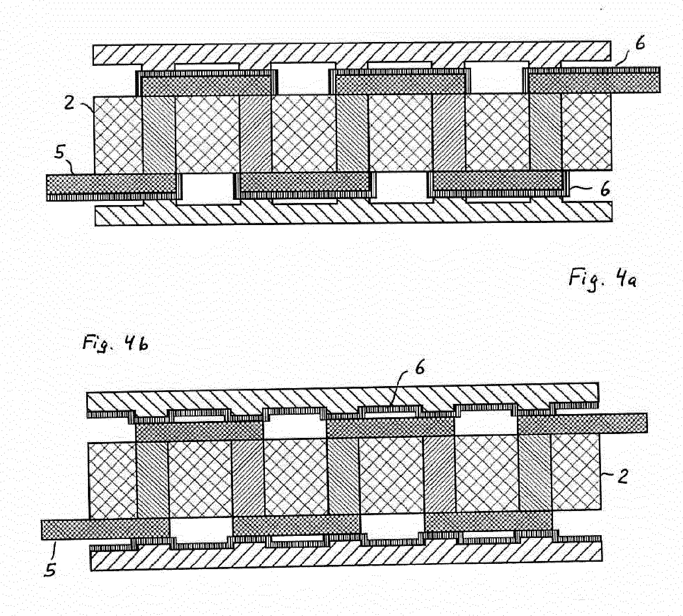

Die Figuren 4a-4d zeigen Ausführungsformen mit veränderter Isolationsschicht (6).

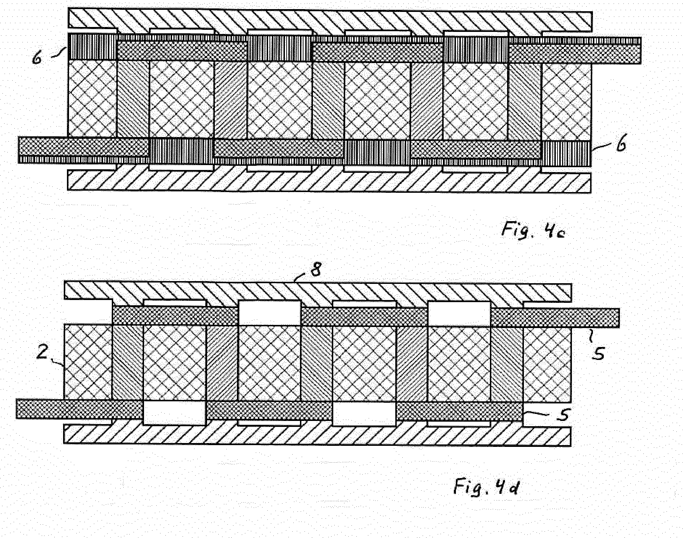

Die Figur 4a zeigt eine Ausführungsform, bei der die elektrische Isolationsschicht (6) die Matrix (2) nicht bedeckt oder umgibt. Lediglich die Schaltverbindungen (Kontakte) (5) sind mit der elektrischen Isolation (6) beschichtet. In einer weiteren Ausführung könnte auch auf eine Isolationsschicht verzichtet werden, wenn die Wärmeleitelemente (8, 9) selbst elektrisch isolierend sind (Fig. 4d).

In Figur 4b umgibt die Isolationsschicht (6) die Wärmeleitelemente (8, 9) und entspricht ansonsten dem in Figur 3 und 4a gezeigten Aufbau.

In Figur 4c sind die Zwischenräume der elektrischen Schaltverbindung (5) vollgefüllt mit dem elektrischen Isolationsmaterial (6), so dass die Oberfläche planar wird.

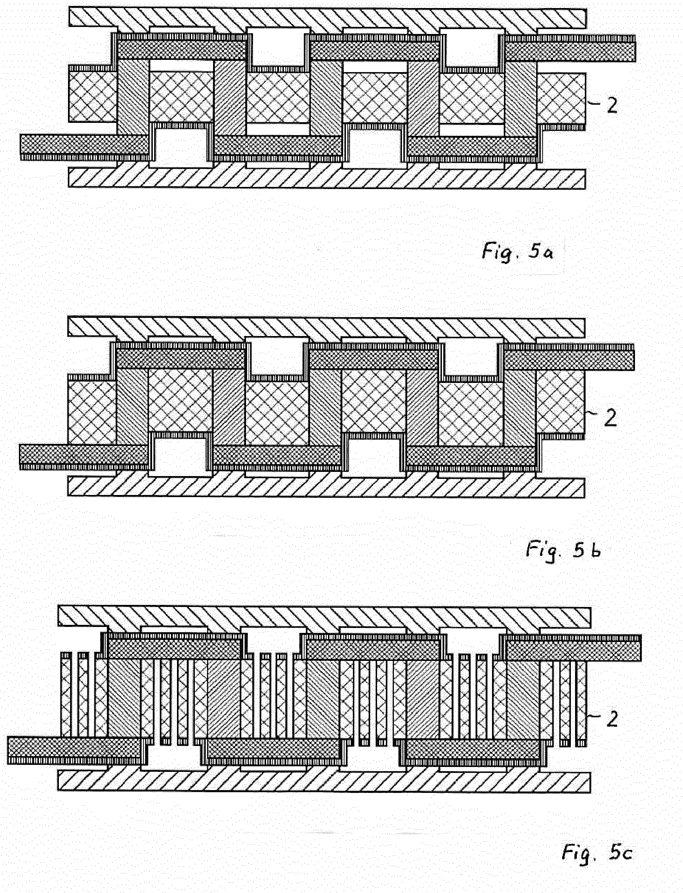

Die Figuren 5a-5c zeigen Ausführungsformen, bei denen die Matrix verändert wurde. Dies kann mittels ätzen, bohren, schleifen, fräsen, lasern oder stanzen geschehen. Auch kann das Matrix-Material geschäumt sein oder es wird schon bei der Herstellung mit der gewünschten Struktur gegossen. Der Raum zwischen den einzelnen Schaltverbindungen (5) kann dabei gemäss Figur 3 auch mit einem anderen Material als Luft (oder Vakuum) ausgefüllt sein.

Die Matrix (2) weist dabei die gleiche Dicke wie die Halbleiter (3, 4) auf oder kann auch dünner sein (Fig. 5a), ist nicht planparallel (Fig. 5b), wobei die Matrix (2) so ausgebildet resp. eingebracht sein kann, dass sie die Halbleiter (3, 4) nur teilweise umhüllt (Fig. 5b).

Oder in das Matrixmaterial (2) sind Hohlräume (11) über die gesamte Länge oder auch nur über einen Teil der Länge eingebracht (Fig. 5c).

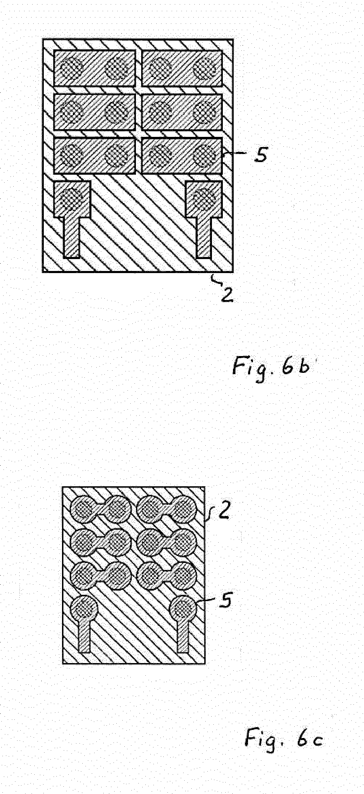

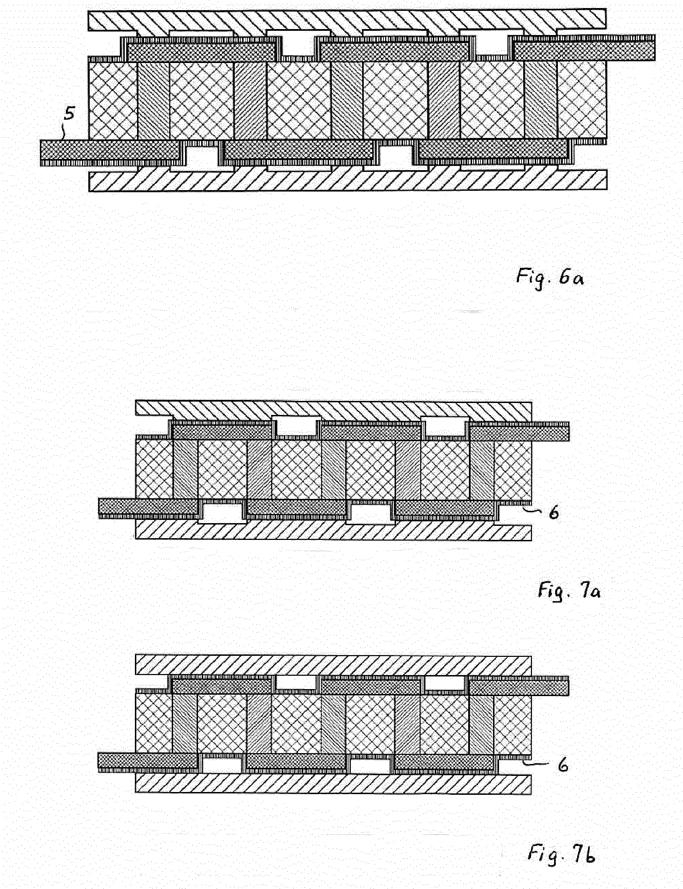

Nach Figur 3 überdecken die Schaltverbindungen (5) die Halbleiter (3, 4) bündig, unter Meidung von Überlappungen resp. Überständen. Andererseits sind auch Überstände möglich (Fig. 6a). Figur 6b und 6c zeigen eine Draufsicht auf den TEK. Figur 6a und Figur 6b zeigen eine geometrische Auslegung der Schaltverbindungen (5), welche die mögliche Einspeisung parasitärer Wärmeströme in die Matrix (2) über die Schaltverbindungen (5) nicht berücksichtigt. Fig. 6c zeigt eine optimierte geometrische Auslegung der Schaltverbindungen (5), welche dank einer geringeren Kontaktfläche zur Matrix (2) für eine reduzierte Einspeisung parasitischer Wärmeströme in die Matrix sorgt.

Die Figuren 7a und b zeigen mögliche Variationen der Thermoleitelemente (8, 9) auf. Die Thermoleitelemente (8, 9) können wie Bei Figur 3 Aussparungen enthalten an der Stelle wo sich die Luftpolster (7, 10) befinden, welche geätzt, gefräst, gebohrt, gestanzt, funkenerodiert oder gelasert worden sind oder welche bei der Herstellung der Thermoleitelemente (8,9), zum Beispiel durch giessen, in eine Strukturform mit eingebaut wurden. Je nach Ausführung können solche Aussparungen auch fehlen (Figur 7b). In diesem Fall sind die Luftpolster (7, 10) durch die Dicke der elektrischen Schaltverbindungen (5) gegeben oder sie können auch, wie in Figur 7a, nur an denjenigen Stellen auftreten, bei denen keine elektrischen Schaltverbindungen vorhanden sind.

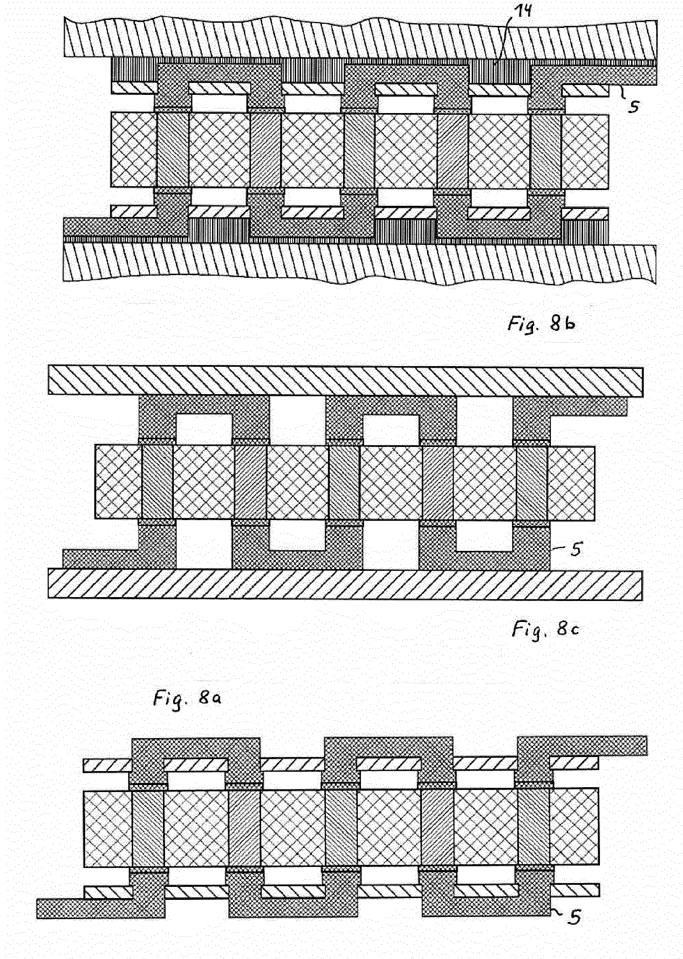

In Figur 8 ist eine Ausführungsform dargestellt, die das Ziel hat, den Wärmefluss durch die Matrix (2) noch stärker zu verringern. Um dies zu erreichen, werden die der kalten sowie der warmen Grenzfläche zugewandten Schaltverbindungen (5) in einem separaten Prozess auf einem separaten elektrisch isolierenden Substrat (14) hergestellt. Die elektrische Verbindung mit den Halbleitern (3, 4) an der Abflussstirnfläche wird mittels z. B. einer Lötverbindung (17) hergestellt. Die Ausführungsform in Figur 8a zeigt eine Variante, in welcher die Schaltverbindungen (5) auf der der Grenzfläche zugewandten Seite des Substrats (14) aufgebracht sind und durch Bohrungen der Kontakt zu den Halbleitern (3, 4) ermöglicht wird. In der Ausführung in Figur 8b sind die Schaltverbindungen auf der den Halbleitern (3, 4) zugewandten Seiten angebracht. In dieser Ausführung (Figur 8b) sind die Wärmeleitelemente (8, 9) elektrisch isolierend. Ausführung 8c zeigt eine mögliche thermische Anschlussvariante der Ausführung in 8a. Dabei werden die Wärmeleitelemente (8, 9) analog zu Figur 2b mittels eines thermisch leitfähigen Klebers (15) an die thermischen Grenzflächen angebracht.

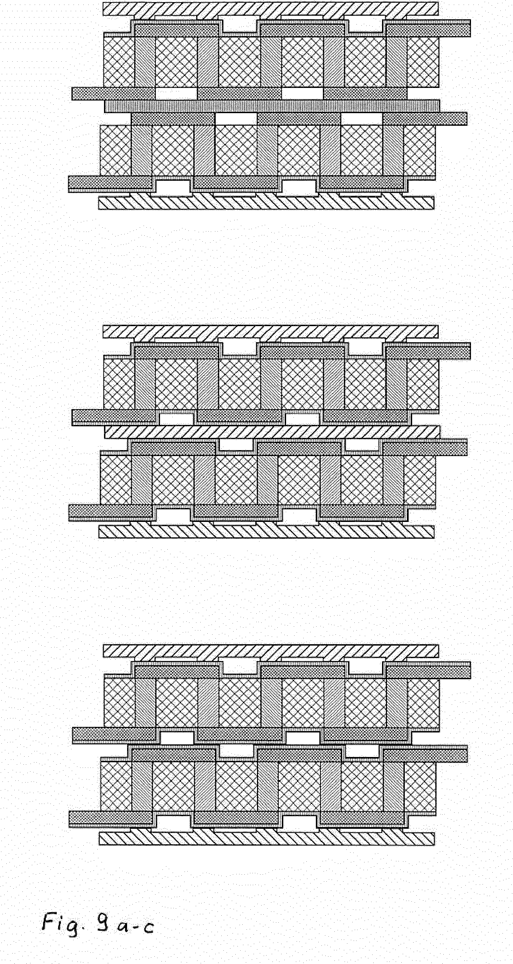

In Figur 9 ist eine Ausführungsform gezeigt, in welcher 2 oder mehr TEKs aufeinander gestapelt sind. Dabei kann die Ausgestaltung der Seite der kalten und warmen Grenzfläche gemäss einer der Ausführungsformen von Figur 3-8 sein. Die innenliegenden Grenzflächen zwischen dem oberen und unteren TEK weisen nun auch Luftpolster (7, 10) aus. Die Kontaktfläche zwischen den TEKs kann entweder direkt durch die Isolationsschicht (6) dargestellt sein (Fig. 9a), es kann ein Wärmeleitelement (8) dazwischengeschaltet sein (Fig. 9b) oder es kann eine Isolationsschicht (15) sein, welche als Kleber ausgestaltet ist und so die beiden TEKs zusammenhält (Fig. 9c).

Die Hauptbestandteile können weiter variiert werden, so dass die Anzahl der aufgezeigten Ausführungsformen nicht abschliessend ist. Allen Varianten ist jedoch gemeinsam, dass Luftpolster oder Luft- oder Vakuumeinschlüsse wie beschrieben vorhanden sind, welche den Wirkungsgrad (Performance) verbessern.

Liste der Bezugszeichen

| | |
|---|---|
| 1 | TEK |
| 2 | Matrix |
| 3 | Halbleiter n-Typ |
| 4 | Halbleiter p-Typ |
| 5 | Schaltverbindung |
| 6 | Elektrische Isolation |
| 7 | Luftpolster kalte Seite |
| 8 | Wärmeleitelement kalte Seite |
| 9 | Wärmeleitelement warme Seite |
| 10 | Luftpolster warme Seite |
| 11 | Hohlraum |
| 12 | kalte Seite (Wärmesenke) |
| 13 | heisse Seite (Wärmequelle) |
| 14 | Elektrisch isolierendes Substrat |

15 Thermisch leitfähiger Kleber
16 Thermisches Montagematerial (z. B. Wärmeleitpaste oder thermisch leitfähige Transferklebefolie)
17 Lotverbindung
$K_{TEK}$ thermischer Widerstand eines TEK [K/W]
$K_{T1}$ thermischer Widerstand zwischen TEK Oberfläche und warmer Seite. [K/W]
$K_{T2}$ thermischer Widerstand zwischen TEK Oberfläche und kalter Seite. [K/W]
$K_{PILE}$ thermischer Widerstand aller Thermopsäulen in einem TEK [K/W]
$K_{PAR}$ parasitärer thermischer Widerstand des Matrix Materials eines TEKs [K/W]

T Temperatur [K]
P elektrische Leistung [W]
U elektrische Spannung [V]

## Patentansprüche

1. Thermoelektrischer Konverter resp. ein Thermoelement zur Gewinnung von elektrischer Energie, umfassend thermoelektrische Halbleiter (3, 4) vom n-Typ resp. p-Typ zwischen Hüllplatten in Form von thermisch hochleitfähigen Wärmeleitelementen (8, 9), die parallel voneinander beabstandet und in abwechselnder Reihenfolge in einer strukturtragenden Matrix (2) angeordnet resp. eingebettet sind, wobei jeweils ein Halbleiter des n-Typs (3) über eine Schaltverbindung (5) mit einem Halbleiter des p-Typs (4) verbunden ist und die einzelnen Schaltverbindungen (5) mittels einer Isolation (6) elektrisch von den Wärmeleitelementen (8,9) isoliert sind, **dadurch gekennzeichnet, dass** die Grenzfläche der Matrix (2) zum angrenzenden Wärmeleitelement (8) flächige Unterbrechungen (7, 9) aufweist, womit die Kontaktfläche zwischen Wärmeleitelementen (8) zur Matrix (2) reduziert ist, die für eine reduzierte Einspeisung parasitischer Wärmeströme in die Matrix (2) sorgt.

2. Thermoelektrischer Konverter nach Anspruch 1, **dadurch gekennzeichnet, dass** die Unterbrechungen (7, 9) mit einem Medium gefüllt sind, dessen thermische Leitfähigkeit kleiner 0,2 W/m/K, bevorzugt kleiner 0,5 W/m/K und besonders bevorzugt kleiner 1 W/m/K ausgebildet sind.

3. Thermoelektrischer Konverter nach Anspruch 1 oder 2, **dadurch gekennzeichnet, dass** das die Unterbrechungen (7, 9) mit Luft gefüllt sind oder vakuumiert sind.

4. Thermoelektrischer Konverter nach einem der Ansprüche 1 bis 3, **dadurch gekennzeichnet, dass** das Luftpolster (7, 9), die Aussparung oder dergleichen eine Ausdehnung von mindestens 2 um, bevorzugt von mindestens 10 um und besonders bevorzugt von mindestens 100 um aufweist.

5. Thermoelektrischer Konverter nach einem der Ansprüche 1 bis 4, **dadurch gekennzeichnet, dass** die Isolation (6) Aussparungen aufweist.

6. Thermoelektrischer Konverter nach einem der Ansprüche 1 bis 5, **dadurch gekennzeichnet, dass** die Matrix (2) die gleiche Dicke oder eine geringere Dicke als die Halbleiter (3, 4) aufweist.

7. Thermoelektrischer Konverter nach mindestens einem der Ansprüche 1 bis 6, **dadurch gekennzeichnet, dass** die Isolationsschicht (6) das Wärmeleitelement (8) umgibt.

8. Thermoelektrischer Konverter nach einem der Ansprüche 1 bis 7, **dadurch gekennzeichnet, dass** in das Matrixmaterial (2) Hohlräume (11) über die gesamte Länge oder auch nur über einen Teil der Länge eingebracht sind.

9. Thermoelektrischer Konverter nach einem der Ansprüche 1 bis 8, **dadurch gekennzeichnet, dass** die der Wärmeleitelemente (8) der kalten sowie der warmen Seite zugewandten Schaltverbindungen (5) auf einem separaten elektrisch isolierenden Substrat (14) hergestellt sind.

10. Thermoelektrischer Konverter nach einem der Ansprüche 1 bis 9, **dadurch gekennzeichnet, dass** die Halbleiter (3, 4) aus Bi2Te3, SbTe, SbBiTe, Se,Bi,Te, Cu, Ni, SbBi, ZnBi, ZnTe, ZnSb o. a. bestehen.

11. Thermoelektrischer Konverter nach einem der Ansprüche 1 bis 9, **dadurch gekennzeichnet, dass** die Matrix (2) aus einem Kunststoff und/oder aus Glas, Si, SiO2 oder PCB-Werkstoffen besteht, deren Wärmeleitfähigkeit grösser ist als die von Luft.

12. Thermoelektrischer Konverter nach einem der Ansprüche 1 bis 10, **dadurch gekennzeichnet, dass** die Isolationsschicht (6) aus einem Polymer, einem keramischen Werkstoff (z. B. Al2O3), einem thermisch leitfähigen Polymer oder einer thermisch leitfähigen Folie aus Keramik besteht.

13. Thermoelektrischer Konverter nach Anspruch 1, **dadurch gekennzeichnet, dass** die Isolationsschicht (6) flächige Unterbrechungen (7, 9) zwischen zwei benachbarten Schaltverbindungen (5) sowie zum angrenzenden Wärmeleitelement (8) und zur angrenzenden Matrix (2) aufweist.

14. Vorrichtung mit mindestens zwei thermoelektrischen Konvertern nach einem der Ansprüche 1 bis 13, **dadurch gekennzeichnet, dass** mindestens zwei oder mehr TEKs aufeinander gestapelt sind, wobei die innenliegenden Grenzflächen zwischen dem oberen und unteren TEK ebenfalls Luftpolster (7, 9) o. dgl. aufweisen.

15. Vorrichtung mit mindestens zwei thermoelektrischen Konvertern nach Anspruch 14, **dadurch gekennzeichnet, dass** die Kontaktfläche zwischen den TEKs direkt an der Isolationsschicht (6) gelegen sein kann oder ein Wärmeleitelement (8) dazwischengeschaltet ist oder eine Isolationsschicht (15) dazwischengeschaltet ist, welche als Kleber ausgestaltet ist.

## Claims

1. A thermoelectric converter or a thermoelement for recovering electrical energy, comprising thermoelectric semiconductors (3, 4) of the n-type and p-type between encasing plates in the form of highly thermally conductive heat-conducting elements (8, 9), which are distanced from one another in parallel and are arranged or embedded in an alternating sequence in a structure-supporting matrix (2), wherein in each case a semiconductor of the n-type (3) is connected via a connection (5) to a semiconductor of the p-type (4) and the individual connections (5) are electrically (6) insulated from the heat-conducting elements (8, 9) by means of an insulation, **characterised in that** the interface of the matrix (2) to the adjacent heat-conducting element (8) has planar interruptions (7, 9), whereby the contact area between heat-conducting elements (8) and the matrix (2) is reduced, which ensures a reduced feed of parasitic heat flows into the matrix (2).

2. The thermoelectric converter according to claim 1, **characterised in that** the interruptions (7, 9) are filled with a medium, the thermal conductivity of which is less than 0.2 W/m/K, preferably less than 0.5 W/m/K, and particularly preferably less than 1 W/m/K.

3. The thermoelectric converter according to claim 1 or 2, **characterised in that** the interruptions (7, 9) are filled with air or are vacuumed.

4. The thermoelectric converter according to any one of claims 1 to 3, **characterised in that** the air cushion (7, 9), the recess, or the like has an extension of at least 2 um, preferably of at least 10 um, and particularly preferably of at least 100 um.

5. The thermoelectric converter according to any one of claims 1 to 4, **characterised in that** the insulation (6) comprises recesses.

6. The thermoelectric converter according to any one of claims 1 to 5, **characterised in that** the matrix (2) has the same thickness or a smaller thickness than the semiconductors (3, 4).

7. The thermoelectric converter according to at least one of claims 1 to 6, **characterised in that** the insulation layer (6) surrounds the heat-conducting element (8).

8. The thermoelectric converter according to any one of claims 1 to 7, **characterised in that** cavities (11) are formed in the matrix material (2) over the entire length or also only over part of the length.

9. The thermoelectric converter according to any one of claims 1 to 8, **characterised in that** the connections (5) facing the heat-conducting elements (8) of the cold and the hot side are produced on a separate electrically insulating substrate (14).

**10.** The thermoelectric converter according to any one of claims 1 to 9, **characterised in that** the semiconductors (3, 4) consist of Bi2Te3, SbTe, SbBiTe, Se,Bi,Te, Cu, Ni, SbBi, ZnBi, ZnTe, ZnSb, or the like.

**11.** The thermoelectric converter according to any one of claims 1 to 9, **characterised in that** the matrix (2) consists of a plastic and/or of glass, Si, SiO2 or PCB materials, the thermal conductivity of which is greater than that of air.

**12.** The thermoelectric converter according to any one of claims 1 to 10, **characterised in that** the insulation layer (6) consists of a polymer, a ceramic material (for example Al2O3), a thermally conductive polymer, or a thermally conductive film made of ceramic.

**13.** The thermoelectric converter according to claim 1, **characterised in that** the insulation layer (6) comprises planar interruptions (7, 9) between two adjacent connections (5) and to the adjacent heat-conducting element (8) and to the adjacent matrix (2).

**14.** A device having at least two thermoelectric converters according to any one of claims 1 to 13, **characterised in that** at least two or more TECs are stacked one on top of the other, wherein the inner interfaces between the upper and the lower TEC likewise comprise air cushions (7, 9) or the like.

**15.** The device having at least two thermoelectric converters according to claim 14, **characterised in that** the contact area between the TECs can be placed directly against the insulation layer (6) or a heat-conducting element (8) is arranged in-between or an insulation layer (15) is arranged in-between and is embodied as adhesive.

**Revendications**

**1.** Convertisseur thermoélectrique, respectivement un thermocouple, destiné à obtenir de l'énergie électrique, comprenant :

des semi-conducteurs thermoélectriques (3, 4), de type n, respectivement de type p, entre des plaques enveloppantes, sous la forme d'éléments thermo-conducteurs (8, 9) hautement conducteurs thermique, qui sont placés, respectivement encastrés dans une matrice (2) porteuse de structure en étant écartés à la parallèle les uns des autres et dans un ordre successif alterné, chaque fois un semi-conducteur du type n (3) étant connecté par l'intermédiaire d'une liaison de commutation (5) avec un semi-conducteur du type p (4) et les liaisons de commutation (5) individuelles étant isolées électriquement des éléments semi-conducteurs (8, 9) au moyen d'une isolation (6),
**caractérisé en ce que** la surface limite de la matrice (2) comporte par rapport à l'élément thermoconducteur (8) adjacent des interruptions (7, 9) planes, suite à quoi, la surface de contact entre des éléments thermo-conducteurs (8) et la matrice (2), qui assure une alimentation réduite de courants thermiques parasites dans la matrice (2) est réduite.

**2.** Convertisseur thermoélectrique selon la revendication 1, **caractérisé en ce que** les interruptions (7, 9) sont remplies d'un agent, dont la conductibilité thermique est inférieure à 0,2 W/m/K, de préférence inférieure à 0,5 W/m/K et de manière particulièrement préférentielle, inférieure à 1 W/m/K.

**3.** Convertisseur thermoélectrique selon la revendication 1 ou 2, **caractérisé en ce que** les interruptions (7, 9) sont remplies d'air ou sont placées sous vide.

**4.** Convertisseur thermoélectrique selon l'une quelconque des revendications 1 à 3, **caractérisé en ce que** le coussin d'air (7, 9), l'encoche ou similaire présente une extension d'au moins 2 pm, de préférence d'au moins 10 pm et de manière particulièrement préférentielle, d'au moins 100 pm.

**5.** Convertisseur thermoélectrique selon l'une quelconque des revendications 1 à 4, **caractérisé en ce que** l'isolation (6) comporte des encoches.

**6.** Convertisseur thermoélectrique selon l'une quelconque des revendications 1 à 5, **caractérisé en ce que** la matrice (2) présente la même épaisseur ou une plus faible épaisseur que les semi-conducteurs (3, 4).

**7.** Convertisseur thermoélectrique selon l'une quelconque des revendications 1 à 6, **caractérisé en ce que** la couche isolante (6) entoure l'élément thermoconducteur (8) .

8. Convertisseur thermoélectrique selon l'une quelconque des revendications 1 à 7, **caractérisé en ce que** dans la matière de la matrice (2), des cavités (11) sont ménagées sur toute la longueur ou également sur seulement une partie de la longueur.

9. Convertisseur thermoélectrique selon l'une quelconque des revendications 1 à 8, **caractérisé en ce que** les liaisons de commutation (5) qui font face aux éléments thermo-conducteurs (8) du côté froid ainsi que du côté chaud sont créées sur un substrat (14) isolant électrique séparé.

10. Convertisseur thermoélectrique selon l'une quelconque des revendications 1 à 9, **caractérisé en ce que** les semi-conducteurs (3, 4) sont constitués de B12Te3, de SbTe, de SbB1Te, de Se, de Bi, de Te, de Cu, de Ni, de SbB1, de Znb1, de ZnTe, de ZnSb ou analogues.

11. Convertisseur thermoélectrique selon l'une quelconque des revendications 1 à 9, **caractérisé en ce que** la matrice (2) est constituée d'une matière plastique et/ou de verre, de Si, de SiO2 ou de matières PCB, dont la conductibilité thermique est supérieure à celle de l'air.

12. Convertisseur thermoélectrique selon l'une quelconque des revendications 1 à 10, **caractérisé en ce que** la couche isolante (6) est constituée d'un polymère, d'une matière céramique (par ex. de l'Al2O3), d'un polymère thermo-conductible ou d'un film en céramique thermo-conductible.

13. Convertisseur thermoélectrique selon l'une quelconque des revendications 1 à 10, **caractérisé en ce que** la couche isolante (6) comporte des interruptions (7, 9) planes entre deux liaisons de commutation (5) voisines, ainsi que vers l'élément thermoconducteur (8) adjacent et vers la matrice (2) adjacente.

14. Dispositif, pourvu d'au moins un convertisseur thermoélectrique selon l'une quelconque des revendications 1 à 13, **caractérisé en ce qu'**au moins deux convertisseurs thermoélectriques sont empilés l'un sur l'autre, les surfaces limites intérieures entre le convertisseur thermoélectrique supérieur et inférieur comportant également des coussins d'air (7, 9) ou similaires.

15. Dispositif, pourvu d'au moins deux convertisseurs thermoélectriques selon la revendication 14, **caractérisé en ce que** la surface de contact entre les convertisseurs thermoélectriques peut se situer directement sur la couche isolante (6) ou **en ce qu'**un élément thermoconducteur (8) est intercalé, ou **en ce qu'**une couche isolante (15), laquelle est conçue sous la forme d'un agent adhésif est intercalée.

Fig. 1a

Fig. 16

Fig. 2a

Fig. 2b

Fig. 3

Fig. 4a

Fig. 4b

Fig. 4c

Fig. 4d

Fig. 5a

Fig. 5b

Fig. 5c

Fig. 6b

Fig. 6c

Fig. 6a

Fig. 7a

Fig. 7b

Fig. 8b

Fig. 8c

Fig. 8a

Fig. 9 a-c

**EP 2 939 279 B1**

**IN DER BESCHREIBUNG AUFGEFÜHRTE DOKUMENTE**

**In der Beschreibung aufgeführte Patentdokumente**

- US 6300150 B1
- DE 19845104 A1
- WO 2008061823 A2
- US 6519947 B
- US 20050126184 A
- US 20130269743 A